# EUROPÄISCHE PATENTANMELDUNG

(11) **EP 4 703 735 A1**
(43) Veröffentlichungstag der Anmeldung: **04.03.2026**
(21) Anmeldenummer: 24197505.1
(22) Anmeldetag: 30.08.2024
(51) Int. Cl.: G01R 15/24

(54) **ELEKTRONISCHE BAUGRUPPE**

(71) Anmelder: Siemens Aktiengesellschaft, 80333 München (DE)
(72) Erfinder: Nerreter, Stefan, 15754 Heidesee OT Blossin (DE); Strogies, Jörg, 14163 Berlin (DE); Wetzel, Ulrich, 91325 Adelsdorf (DE)
(74) Vertreter: Siemens Patent Attorneys

(57) **Zusammenfassung**

Die Erfindung betrifft eine Elektronische Baugruppe (2) mit mindestens einem elektronischen Bauelement (4), mindestens einer Leiterplatte (8), wobei Bauelement (4) und Leiterplatte (8) horizontal in verschiedenen Ebenen (E1, E2... En) innerhalb der Baugruppe (2) zueinander verlaufen, wobei Kontaktierungen (10) des elektronischen Bauelementes (4) vertikal in der Baugruppe (2) verlaufen. Die Erfindung zeichnet sich dadurch aus, dass
- in horizontaler Einbaulage eine Glasplatte (12) in die Baugruppe (2) eingebracht ist,
- die eine horizontale Aussparung (14) aufweist durch die mindestens ein Teil der Kontaktierungen (10) geführt ist, wobei
- in die Glasplatte (12) ein optischer Wellenleiter (16) strukturiert ist und
- die Glasplatte zwei optische Anschlussstellen (32, 34) an den Wellenleiter (15) aufweist, mittels derer polarisiertes Laserlicht (20) in den Wellenleiter (16) einkoppelbar ist und auskoppelbar ist.

## Beschreibung

Die Erfindung betrifft eine elektronische Baugruppe nach dem Oberbegriff des Patentanspruchs 1.

In elektronischen Baugruppen, insbesondere in der Leistungselektronik, also Baugruppen, die in einem Leistungselektronikmodul verbaut sind, ist für die gezielte Steuerung der Baugruppen oder Module eine chipnahe Messung des fließenden Stromes wünschenswert. Bisher werden Ströme beispielsweise durch sogenannte Shunt-Widerstände oder durch sogenannte Hallwandler außerhalb der Baugruppe oder des Moduls gemessen. Die Möglichkeit Ströme an einzelnen Bauelementen in einem Modul oder in einer Baugruppe zu messen, ist nicht bekannt.

Die Aufgabe der Erfindung besteht darin, eine elektronische Baugruppe und ein Leistungselektronikmodul bereitzustellen, die es ermöglichen, fließende Ströme in der Baugruppe in unmittelbarer Nähe des Chips, also des Bauelementes, zu messen.

Die Lösung der Aufgabe besteht in einer elektronischen Baugruppe mit den Merkmalen des Patentanspruchs 1.

Die beschriebene elektronische Baugruppe weist dabei mindestens ein elektronisches Bauelement und eine Leiterplatte auf, wobei Bauelement und Leiterplatte horizontal in verschiedenen Ebenen innerhalb der Baugruppe zueinander verlaufen. Ferner sind Kontaktierungen des elektronischen Bauelementes vorgesehen, die vertikal in der Baugruppe verlaufen. Die Erfindung zeichnet sich dadurch aus, dass in horizontaler Einbaulage eine Glasplatte in die Baugruppe eingebracht ist, die eine horizontale Aussparung aufweist, durch die mindestens ein Teil der Kontaktierung geführt ist. In die Glasplatte ist ferner ein optischer Wellenleiter strukturiert, wobei die Glasplatte für den optischen Wellenleiter optische Anschlussstellen aufweist, mittels derer polarisiertes Laserlicht in den Wellenleiter einkoppelbar und wieder auskoppelbar ist.

Die Erfindung bewirkt, dass die vertikal durch die Aussparung in der Glasplatte verlaufenden Kontaktierungen bei einem Stromfluss durch die Kontaktierung, also auch bei einem Stromfluss durch das Bauelement an sich, ein magnetisches Feld um die Kontaktierung herum induzieren, wodurch unter Nutzung des optischen Faraday-Effektes polarisiertes Laserlicht, das durch den in die Glasplatte integrierten Wellenleiter verläuft, in seiner Polarisation abgelenkt wird. Durch die Messung der Änderung der Polarisation des Laserlichtes, z. B. durch einen optischen Detektor, kann auf die Intensität des durch die Aussparung der Glasplatte verlaufenden elektrischen Kontaktierungen in der Baugruppe geschlossen werden. Da die Glasplatte sehr klein ausgestaltet werden kann und auch sehr dünn ist, sie weist üblicherweise zwischen 200 µm und 1 mm in der Dicke auf, kann diese ohne großen technischen Aufwand in eine Ebene der Baugruppe so integriert werden, dass sich der Bauraum der Baugruppe nur unwesentlich erweitert.

Somit ist eine chipnahe, also bauteilnahe Messung von Stromflüssen einzelner Bauelemente, beispielsweise Transistoren und/oder Dioden innerhalb der Baugruppe, insbesondere innerhalb einer Leistungselektronikbaugruppe, in der leistungselektronische Bauelemente, wie Leistungstransistoren oder Dioden verbaut sind, möglich. Die Baugruppe kann im Weiteren Bestandteil eines größeren elektronischen Systems, beispielsweise eines Leistungselektroniksystems wie beispielsweise eines Inverters sein.

Die Baugruppe ist dabei bevorzugt so ausgestaltet, dass das Bauelement mindestens zwei stromführende Kontaktierungen aufweist. Bei einer Diode handelt es sich in der Regel um zwei stromführende Kontaktierungen, bei einem Transistor sind mindestens drei stromführende Kontaktierungen vorhanden. Dabei ist es zweckmäßig, dass mindestens eine der stromführenden Kontaktierungen durch die Aussparung der Glasplatte verläuft. Dabei kann es zweckmäßig sein, dass dies bei einem Transistor, insbesondere bei einem Feldeffekttransistor, die sogenannte Drain-Kontaktierung ist, da hier größere Ströme fließen.

In einer vorteilhaften Ausgestaltungsform der Erfindung ist die Glasplatte mit der Aussparung zwischen einer Trägerplatte für das Bauelement und dem Bauelement an sich angeordnet. Zwischen der Trägerplatte, die wiederum eine Ebene in der Baugruppe einnimmt, und dem Bauelement ist dabei eine Kontaktierungsebene eingebracht, die vertikal so weit erweitert werden kann, dass die Aussparung der Glasplatte von der Kontaktierung ausgefüllt wird.

In einer alternativen Ausgestaltungsform hierzu ist die Glasplatte mit der Aussparung zwischen zwei Leiterplatten angeordnet, wobei eine Leiterplatte ein sogenannter Interposer ist, was als eine Umverdrahtungs-Leitungsplatte bezeichnet werden kann. Wird ein Interposer verwendet, was in vielen Baugruppen der Fall ist, so wird zudem eine zweite Leiterplatte eingesetzt, zwischen der und dem Interposer eine Anordnung der Glasplatte aus Platzgründen vorteilhaft ist.

Ebenfalls eine alternative Ausgestaltungsform besteht darin, dass die Glasplatte mit der Aussparung in eine der Leiterplatten horizontal integriert ist. Herstellungstechnisch kann das als eine Einlaminierung der Glasplatte in die Leiterplatte bezeichnet werden. Hierbei ist ebenfalls die Leiterplatte, in die die Glasplatte integriert ist, bevorzugt der Interposer. Auch diese Ausgestaltungsform ist besonders bauraumsparend.

Eine weitere vorteilhafte Ausgestaltungsform der Erfindung besteht darin, dass die Kontaktierungen zumindest teilweise in Form von Pins, die am Bauelement angeordnet sind, ausgestaltet sind und die vertikal durch die Leiterplatten geführt sind. Diese vertikal ausgestalteten Pins sind besonders gut dazu geeignet, um durch die Aussparung in der Glasplatte geführt zu werden.

In einer weiteren Ausgestaltungsform der Erfindung ist eine Laserdiode vorgesehen, die zur Einkopplung von polarisiertem Laserlicht in den Wellenleiter dient. Dieser Laserdiode kann grundsätzlich ebenfalls sehr nah an der Baugruppe an sich, oder sogar als Teil der Baugruppe angeordnet sein, es ist jedoch auch möglich, dass durch eine Laserdiode eine Vielzahl von Baugruppen und somit von Wellenleitern in verschiedenen Glasplatten gespeist wird. Beispielsweise kann eine Laserdiode für ein größeres Leistungselektronikmodul vorgesehen sein, wobei das Laserlicht in heranleitenden (Baugruppen externen) Wellenleitern verteilt und auf die einzelnen Baugruppen und die dort angeordneten Glasplatten verteilt wird.

Ebenfalls zweckmäßig ist es, dass ein Polarisator und eine Fotodiode vorgesehen sind, die zur Intensitätsmessung von aus dem Wellenleiter ausgekoppelten Laserlicht dienen. Wie bereits erwähnt, wird das Laserlicht, das durch die Laserdiode eingebracht wird in den Wellenleiter, durch das Magnetfeld, das durch die stromdurchflossenen Kontaktierungen induziert wird, in seiner Polarisation verändert. Durch die Fotodiode kann das Maß der Veränderung der Polarisation des eingekoppelten Laserlichts gemessen werden und somit auf den Stromfluss geschlossen werden. Grundsätzlich ist hierfür eine Fotodiode besonders gut geeignet.

Die Glasplatte und der darin verlaufende Wellenleiter sind bevorzugt so ausgestaltet, dass der Wellenleiter innerhalb der Glasplatte einen möglichst hohen Weg zurücklegt, um eine möglichst genaue Messung des durch den Strom induzierten Faraday-Effektes vorzunehmen. Dabei ist es zweckmäßig, wenn der Wellenleiter innerhalb der Glasplatte mindestens einmal um die Aussparung herumgeführt wird. Dies kann auch häufiger erfolgen, um den Weg weiter zu verlängern. Auch eine vertikale Umlenkung in mehreren Ebenen der Glasplatte ist zur Verlängerung des Weges des Wellenleiters innerhalb der Glasplatte zweckmäßig. Dabei gibt es technische Verfahren, die dazu geeignet sind, auch in tieferen Ebenen der Glasplatte einen Wellenleiter zu strukturieren.

Weitere Ausgestaltungsformen und weitere Merkmale der Erfindung werden anhand der folgenden Figuren näher erläutert. Dabei handelt es sich um rein schematische Ausgestaltungsformen, die keine Einschränkung des Schutzbereichs darstellen. Merkmale mit derselben Bezeichnung und unterschiedlichen Ausgestaltungsformen in den einzelnen Figuren werden dabei mit denselben Bezugszeichen versehen.

Dabei zeigen:
- Figur 1: einen Querschnitt durch eine elektronische Baugruppe in Form einer Leistungselektronikbaugruppe mit einer Dünnglasplatte, in die ein Wellenleiter strukturiert ist;
- Figur 2a: eine Draufaufsicht auf eine Glasplatte, eine Dünnglasplatte mit einer Aussparung und einem einstrukturierten Wellenleiter;
- Figur 2b: die Glasplatte nach Figur 2a im Querschnitt,
- Figur 3: eine schematische Veranschaulichung des elektrischen Farady-Effektes, der bei der Messung der Ströme in elektronischen Baugruppen genutzt wird;
- Figur 4: eine analoge Baugruppe zu Figur 1, mit einer alternativen Anordnung der Glasplatte mit Wellenleiter und
- Figur 5: eine weitere analoge Ausgestaltungsform der Baugruppe gemäß Figur 1 und Figur 4.

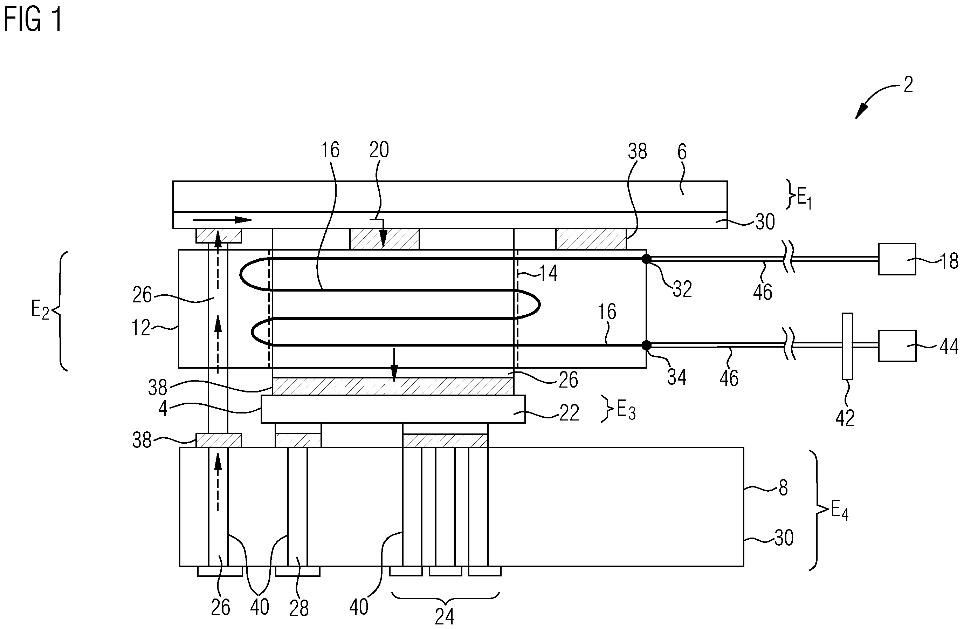

In Figur 1 ist schematisch ein Querschnitt durch eine Baugruppe 2 für ein leistungselektronisches Modul dargestellt. Der übliche Aufbau einer derartigen Baugruppe umfasst dabei ein Bauelement 4, das üblicherweise auf einer keramischen Trägerplatte 6 mittels einer dazwischen befindlichen Metallisierungsschicht 36 und Lötverbindungen 38, die auch als Kontaktierungen dienen, befestigt ist. Ferner ist eine Leiterplatte 8 vorgesehen, die in diesem Beispiel gemäß Figur 1 in Form eines Interposers ausgestaltet ist, wobei ein Interposer eine Umverdrahtungs-Leiterplatte ist. Die Kontaktierung des Bauelementes 4 in die Leiterplatte 8 erfolgt durch Durchkontaktierungen 40 und oder Pins 40 (es wird für Pins und Durchkontaktierungen aufgrund der äquivalenten Wirkung dasselbe Bezugszeichen 40 verwendet), die durch die Leiterplatte 8 durchgesteckt sind und an dieser verlötet oder anderweitig befestigt sind. Bei dem Bauelement 4 handelt es sich im vorliegenden Fall um einen Transistor 22, der als Leistungselektronikbauteil beispielsweise für einen Gleichrichter ausgestaltet ist. Der Transistor 22 als Bauteil 4 in Figur 1 hat dabei üblicherweise mindestens drei Kontaktierungen. Betrachtet man einen Feldeffekttransistor, so spricht man zum einen von einer Source-Kontaktierung 24, einer Drain-Kontaktierung 26 und einer Gate-Kontaktierung 28. Würde es sich um einen Bipolartransistor handeln, würden die Anschlüsse entsprechend Emitter, Kollektor und Basis genannt werden. Bei dem Feldeffekttransistor beispielsweise einem MOSFET, wie er hier betrachtet werden soll, dient die Gate-Kontaktierung 28 dazu, eine Steuerspannung anzulegen, mittels derer der Transistor 22 zwischen den Kontaktierungen Drain 26 und Source 24 durchgängig geschaltet wird, sodass zwischen den beiden Kontaktierungen Source 24 und Drain 26 ein elektrischer Strom fließt. Dabei liegt bei einem Leistungstransistor die höhere Spannung auf der Seite der Drain-Kontaktierung 26, hier sind zwischen 750 V und 1500 V übliche anliegende Potenziale. Im Gegensatz dazu liegt an der Source-Kontaktierung 24 in der Regel eine niedrigere Spannung zwischen 600 V und 700 V vor. Bei dem hier gewählten Aufbau gemäß Figur 1 ist zu erkennen, dass die Drain-Kontaktierung 26 so gestaltet ist, dass sie von der Leiterplatte 8 über die vorliegenden Pins 40 in Richtung der Keramikträgerplatte 6 geführt wird, dort über die Metallisierungsschicht 36 (in der Regel Kupfer) auf eine sogenannte Oberseite des Transistors 22 geführt ist. In der Ausgestaltung gemäß Figur 1, die auch üblich für Leistungselektronik ist, wird der Transistor 22 von einer Ober- und einer Unterseite her kontaktiert. Die Source-Kontaktierung 24 erfolgt ebenfalls über Pins 40 auf die Unterseite des Transistors 22, wie dies in Figur 1 zu erkennen ist. Auch die Gate-Kontaktierung 28 erfolgt von der Unterseite des Transistors 22.

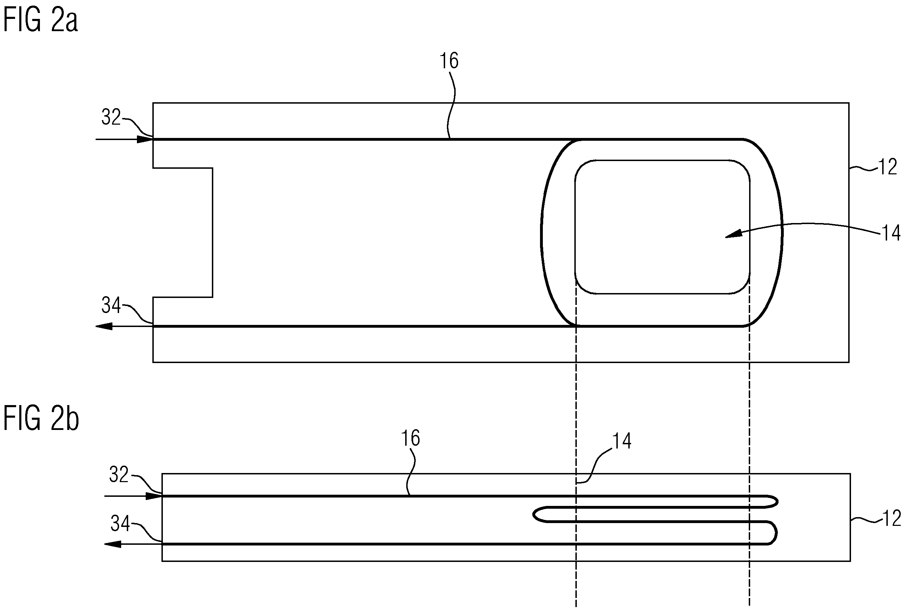

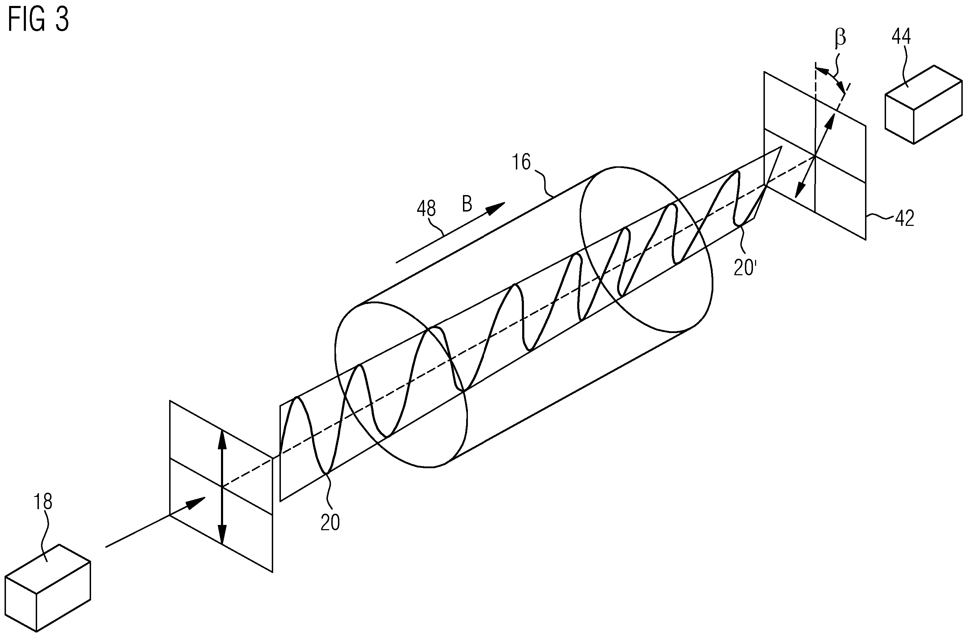

Insoweit ist im vorhergehenden Absatz eine übliche Baugruppe 2 für ein Leistungsmodul beschrieben. Die Darstellung gemäß Figur 1 unterscheidet sich von einer herkömmlichen Baugruppe nach dem Stand der Technik darin, dass hier in einer weiteren Ebene E2 eine Glasplatte 12 horizontal eingebracht ist, die dieselbe horizontale Erstreckung hat, wie der Interposer 8 und die keramische Trägerplatte 6 des Bauteils 4. In der Ausgestaltung gemäß Figur 1 ist diese Glasplatte 12 zwischen der Trägerplatte 6 und dem Bauelement 4 angeordnet. Bei der Darstellung gemäß Figur 1 handelt es sich um eine verzerrte Darstellung, die nicht maßstabsgetreu ist, die Glasplatte 12 weist üblicherweise eine Dicke von 200 µm auf und ist somit dünner als eine herkömmliche Leiterplatte bzw. auch dünner als das Trägerelement 6 oder das Bauteil 4. Die Glasplatte 12 kann jedoch zwischen 200 µm und 800 µm in der Dicke aufweisen. Das besondere an der Glasplatte 12 ist, dass sie eine Aussparung 14 aufweist, durch die zumindest ein Teil der Drain-Kontaktierung 26 vertikal geführt ist. Und die weitere Besonderheit an der Glasplatte 12 besteht darin, dass in ihr ein Wellenleiter 16 strukturiert ist, der als Lichtwellenleiter dient. Dieser Wellenleiter 16 hat wiederum zwei Anschlussstellen, eine optische Anschlussstelle 32 zur Einkopplung von Laserlicht 20 (vgl. Fig. 2a, 2b und 3) und eine weitere optische Anschlussstelle zur Auskopplung 34 des Laserlichtes 20. Ferner sind noch zwei weitere Bauteile vorgesehen, zum einen eine Laserdiode 18, die dazu geeignet ist, über die Anschlussstelle 32 monochromes und polarisiertes Laserlicht 20 (vergleiche Figur 3) in den Wellenleiter 16 einzukoppeln. Dieses Laserlicht 20 durchläuft dabei den Wellenleiter 16, bis es an der Anschlussstelle 34 ausgekoppelt wird und durch einen ebenfalls vorgesehenen Polarisator 42 durch eine Fotodiode als Fotodetektor 44 detektiert wird. Zur Ankopplung von Laserdiode 18 und Fotodetektor 44 können Baugruppen externe Wellenleiter 46 vorgesehen sein.

In Figur 2a ist eine Draufsicht auf die Glasplatte 12 gegeben, in der der Verlauf des Wellenleiters 16 schematisch dargestellt ist. Dabei ist der Wellenleiter 16 in der Art in die Glasplatte 12 eingebracht, dass er von der Anschlussstelle 32 einmal um die Aussparung 14 verläuft und an der Anschlussstelle 34 zur Auskopplung von Laserlicht die Glasplatte 12 verlässt. Ferner ist in Figur 2b zu erkennen, in der ein Querschnitt der Darstellung gemäß Figur 2a gegeben ist, dass der Wellenleiter 16 auch in mehreren Ebenen in der Glasplatte 12 verläuft und dabei sich mäanderförmig ausbreitet, bis er an der Anschlussstelle 34 zur Auskopplung des Laserlichtes angelangt ist. Es ist dabei zweckmäßig, dass der Wellenleiter 16 einen möglichst langen Weg durch die Glasplatte 12 beschreitet, um die optischen Effekte, die im Weiteren noch beschrieben werden, möglichst stark auftreten.

Es ist dabei anzumerken, dass optische Wellenleiter 16 gemäß dem Stand der Technik in Dünnglasplatten mit der Glasplatte 12 durch verschiedene technische Verfahren einbringbar sind. Zum einen ist es möglich, durch nasschemische Verfahren selektiv die optischen Eigenschaften der Glasplatte lokal so zu verändern, dass die Eigenschaften eines Wellenleiters 16 auftreten. Andererseits ist es auch möglich, über Laserverfahren auch in der Tiefe der Glasplatte 12 deren Materialeigenschaften so zu verändern, dass sie einem Wellenleiter 16 gleichkommen.

In Figur 3 ist der optische Effekt, auf dem die beschriebene Glasplatte 12 einschließlich der Laserdiode und dem Fotodetektor 44 basieren, beschrieben. Hierbei handelt es sich um den sogenannten optischen Faraday-Effekt, wobei an diesen Beispielen mittels der Laserdiode 18 monochromes und polarisiertes Laserlicht in den Wellenleiter 16 eingebracht wird. Wird außerhalb des Wellenleiters 16 ein magnetisches Feld 48 angelegt, so wird die Polarisationsebene des Laserlichtes 20 um den Winkel β gemäß Figur 3 verdreht, sodass das so aus dem Wellenleiter 16 austretende Laserlicht 20' eben eine andere Polarisierung aufweist als das Laserlicht 20, das in den Wellenleiter 16 eingekoppelt wird. Das Laserlicht 20' wird durch einen Polarisator 42 geleitet und mittels des Fotodetektors 44 bezüglich seiner Intensität detektiert. Aufgrund des Intensitätsverlustes zwischen dem eingeleiteten Laserlicht 20 und dem ausgeleiteten Laserlicht 20', der insbesondere durch den Polarisator 42 induziert wird, kann auf die Stärke des anliegenden Magnetfeldes 48 rückgeschlossen werden. Dieser Abhängigkeiten können empirisch und mathematisch bestimmt werden. Im Weiteren ist es möglich von dem Magnetfeld 48 auf den Strom zu schließen, der durch die Kontaktierung 24, 26 und/oder 28 fließt. Denn ein stromdurchflossener Leiter induziert nach den Maxwell'schen Gesetzen ebenfalls ein Magnetfeld und dieses Magnetfeld, hier das Magnetfeld 48, wirkt auf den Wellenleiter 16 und auf das in diesem geführte Laserlicht 20. Somit besteht ein kausaler Zusammenhang zwischen dem Strom, der durch die Kontaktierungen 24, 26 und/oder 28 fließt und der Messintensität, die mittels des Detektors 44 ermittelt wird. Somit kann mittels des Detektors 44 auf die Stromstärke rückgeschlossen werden, die durch das Bauelement 4, beispielsweise dem Transistor 22, an entsprechenden Kontaktierungen 24, 26 und/oder 28 fließt. Im Falle der Figur 1 wird die Drain-Kontaktierung 26 und somit der Drain-Strom zwischen der keramischen Trägerplatte 6 und dem Bauelement 4 bestimmt.

Es ist dabei anzumerken, dass sowohl die Laserdiode 18 als auch der Detektor 44 grundsätzlich an der Baugruppe befestigt sein können, bzw. in diese integriert sein können, in den meisten Fällen dürfte es jedoch zweckmäßiger sein, das Laserlicht 20 über die Baugruppen externen Wellenleiter 46 an die Anschlussstellen 32 und 34 der Glasplatte 12 zu transportieren, sodass diese Bauelemente 18, 44 dezentral von der Baugruppe 4 angeordnet sein können, was bauraumsparend ist.

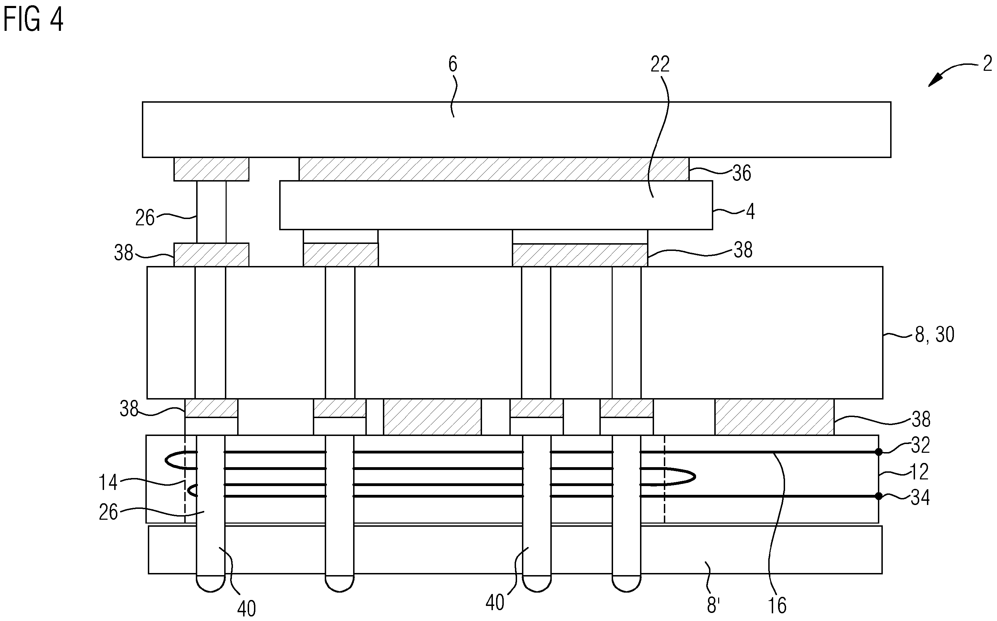

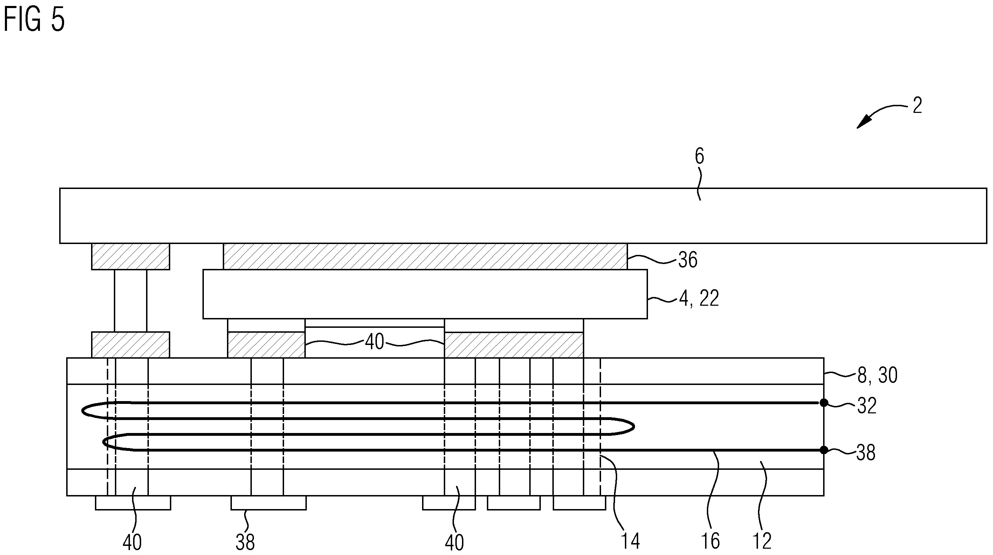

In den Figuren 4 und 5 sind weitere Beispiele für die Anordnung der Glasplatte 12 in der Baugruppe 2 dargestellt. Die Darstellung der Baugruppe 2 gemäß Figur 4 unterscheidet sich von der Baugruppe 2 in Figur 1 darin, dass eine zweite Leiterplatte 8' vorgesehen ist, die neben der Leiterplatte 8 in Form des Interposers 30 vorhanden ist. Diese Leiterplatte 8' dient dazu, mehrere Baugruppen auf einer Leiterplatte zu integrieren. In dieser Ausgestaltungsform ist dann die Glasplatte 12 mit derselben Wirkung, wie bereits zu der Figur 1 beschrieben, zwischen dem Interposer 30 und der zweiten Leiterplatte 8' angeordnet. Ansonsten ist der Aufbau vergleichbar mit dem, wie er bezüglich Figur 1 beschrieben ist.

Auch die Anordnung gemäß Figur 5 ist mit der in Figur 1 vergleichbar. Hierbei ist jedoch die Glasplatte 12 in vorteilhafter Weise in eine Leiterplatte 8, hier in den Interposer 30, integriert. Dabei wird die Glasplatte 12 durch einen Laminierprozess in die Leiterplatte 8 einlaminiert, was eine besonders bauraumsparende Variante darstellt.

### Bezugszeichenliste

- 2: Baugruppe
- 4: Bauelement
- 6: Trägerplatte
- 8: Leiterplatte
- E: Ebenen
- 10: Kontaktierungen
- 12: Glasplatte
- 14: Aussparung
- 16: Wellenleiter
- 18: Laserdiode
- 20: Laserlicht
- 22: Transistor
- 24: Source-Kontaktierung
- 26: Drain-Kontaktierung
- 28: Gate-Kontaktierung
- 30: Interposer ≙ Umverdrahtung Leiterplatte
- 32: optische Anschlussstelle - Einkopplung
- 34: optische Anschlussstelle - Auskopplung
- 36: Metallisierungsschicht
- 38: Lötverbindung
- 40: Pin
- 42: Polarisator
- 44: Fotodetektor
- 46: externer Wellenleiter
- 48: Magnetfeld

## Patentansprüche

1. Elektronische Baugruppe (2) mit mindestens einem elektronischen Bauelement (4), mindestens einer Leiterplatte (8), wobei Bauelement (4) und Leiterplatte (8) horizontal in verschiedenen Ebenen (E1, E2... En) innerhalb der Baugruppe (2) zueinander verlaufen, wobei Kontaktierungen (10) des elektronischen Bauelementes (4) vertikal in der Baugruppe (2) verlaufen, **dadurch gekennzeichnet, dass**
- in horizontaler Einbaulage eine Glasplatte (12) in die Baugruppe (2) eingebracht ist,
- die eine horizontale Aussparung (14) aufweist durch die mindestens ein Teil der Kontaktierungen (10) geführt ist, wobei
- in die Glasplatte (12) ein optischer Wellenleiter (16) strukturiert ist und
- die Glasplatte zwei optische Anschlussstellen (32, 34) an den Wellenleiter (15) aufweist, mittels derer polarisiertes Laserlicht (20) in den Wellenleiter (16) einkoppelbar ist und auskoppelbar ist.

2. Baugruppe nach Anspruch 1, **dadurch gekennzeichnet, dass** das Bauelement (4) ein leistungselektronisches Bauelement (4) ist und die Baugruppe (2) eine Leistungselektronik Baugruppe (2) ist.

3. Baugruppe nach Anspruch 2, **dadurch gekennzeichnet, dass** das Bauelement (2) ein Transistor (22) oder Diode ist.

4. Baugruppe nach Anspruch 3, **dadurch gekennzeichnet, dass** das Bauelement mindestens zwei stromführende Kontaktierung (24, 26) aufweist.

5. Baugruppe nach Anspruch 4, dass mindestens eine der stromführenden Kontaktierungen (24, 26) durch die Aussparung (14) der Glasplatte (12) verlaufen.

6. Baugruppe nach einem der vorhergehenden Ansprüche, **dadurch gekennzeichnet, dass** die Glasplatte (12) mit der Aussparung (14) zwischen einer Trägerplatte (6) und dem Bauelement (4) angeordnet ist.

7. Baugruppe nach einem der Ansprüche 1 bis 4, **dadurch gekennzeichnet, dass** die Glasplatte (12) mit der Aussparung (14) zwischen zwei Leiterplatten (8, 8') angeordnet ist, wobei eine Leiterplatte (8) als Interposer (30) fungiert.

8. Baugruppe nach einem der Ansprüche 1 bis 4, **dadurch gekennzeichnet, dass** die Glasplatte (12) mit der Aussparung (14) in der Leiterplatte (8) horizontal integriert ist.

9. Baugruppe nach Anspruch 7, **dadurch gekennzeichnet, dass** die Leiterplatte (8) der Interposer (30) ist.

10. Baugruppe nach einem der vorhergehenden Ansprüche, **dadurch gekennzeichnet, dass** die Kontaktierungen (24, 26, 28) zumindest teilweise in Form von Pins (40) ausgestaltet sind und vertikal durch die Leiterplatte (8, 8') geführt sind.

11. Baugruppe nach einem der vorhergehenden Ansprüche, **dadurch gekennzeichnet, dass** eine Laserdiode (18) vorgesehen ist, die zur Einkopplung von polarisiertem Laserlicht in den Wellenleiter (16) dient.

12. Baugruppe nach einem der vorhergehenden Ansprüche, **dadurch gekennzeichnet, dass** ein Polarisator (42) und eine Fotodiode (44) vorgesehen ist, die zur Intensitätsmessung von aus dem Wellenleiter (16) ausgekoppelten Laserlicht (20`) dient.

13. Baugruppe nach einem der vorhergehenden Ansprüche, **dadurch gekennzeichnet, dass** der Wellenleiter (16) innerhalb der Glasplatte (12) mindestens einmal um die Aussparung (14) herum verläuft.

14. Baugruppe nach einem der vorhergehenden Ansprüche, **dadurch gekennzeichnet, dass** der Wellenleiter (16) innerhalb der Glasplatte (12) vertikal umgelenkt ist und in mehreren Ebenen der Glasplatte (12) verläuft.
